# EUROPEAN PATENT APPLICATION

(11) **EP 2 579 300 A1**
(43) Date of publication of application: **10.04.2013**
(21) Application number: 11786529.5
(22) Date of filing: 18.05.2011
(51) Int. Cl.: H01L 21/318, C23C 16/42, C23C 16/507, H01L 21/31

(54) **SILICON NITRIDE FILM OF SEMICONDUCTOR ELEMENT, AND METHOD AND APPARATUS FOR PRODUCING SILICON NITRIDE FILM**

(30) Priority: 28.05.2010 JP 2010122252
(71) Applicant: Mitsubishi Heavy Industries, Ltd., Tokyo 108-8215 (JP)
(72) Inventor: NISHIKAWA Seiji, Tokyo 108-8215 (JP)
(74) Representative: Henkel, Breuer & Partner
(86) International application number: PCT/JP2011/061363
(87) International publication number: WO 2011/148830

(57) **Abstract**

Disclosed are: a silicon nitride film of a semiconductor element, which is formed by applying a bias power and appropriately controls hydrogen leaving from the silicon nitride film; and a method and apparatus for producing a silicon nitride film. Specifically disclosed is a silicon nitride film which is formed on a substrate (19) by plasma processing and used in a semiconductor element. If the silicon nitride film is in contact with a film (41) to which supply of hydrogen is required to be shut off, the silicon nitride film is configured of a biased SiN (31) that is formed by applying a bias to the substrate (19) and an unbiased SiN (32) that is formed without applying a bias to the substrate (19) and the unbiased SiN (32) is arranged on the side on which the silicon nitride film is in contact with the film (41).

## Description

### TECHNICAL FIELD

The present invention relates to a silicon nitride film used in a semiconductor element, and a method and an apparatus for producing a silicon nitride film.

### BACKGROUND ART

Plasma CVD methods and plasma CVD apparatuses have been known as methods and apparatuses for manufacturing a silicon nitride film used in a semiconductor element.

### PRIOR ART DOCUMENTS

### PATENT DOCUMENTS

Patent Document 1: Japanese Patent Application Publication No. 2009-177046
Patent Document 2: Japanese Patent Application Publication No. 2006-332538

### SUMMARY OF THE INVENTION

### PROBLEMS TO BE SOLVED BY THE INVENTION

Silicon nitride films (hereinafter, referred to as SiN films) have been used as the lenses of CCD (Charge-Coupled Device) and CMOS (Complementary Metal-Oxide Semiconductor) image sensors for their high refractive indexes and high transmittances, and also used as the final protective films of wirings for their barrier properties. Currently, due to the miniaturization of semiconductor elements, there have been increasing demands for embedding a SiN film in high-aspect-ratio minute holes (holes with a hole diameter: Φ of below 1 µm and an aspect ratio of 1 or above).

To embed a SiN film in high-aspect-ratio minute holes, it is necessary to perform that film formation by applying bias power. In Patent Document 1, the inventor of the present invention and others have proposed a technique in which a SiN film is formed by applying bias power with use of an appropriate process condition. However, since a SiN film formed by applying bias power contains Si-H bonds therein, the hydrogen escapes therefrom when the SiN film is subjected to annealing (400°C) which is performed in a semiconductor manufacturing process. Here, the escaping hydrogen is required to be appropriately controlled depending upon the type of semiconductor element. For example, in a case of ferroelectric memories, there is a problem of deterioration by hydrogen reduction, and it is therefore necessary to block the diffusion of the escaping hydrogen. Moreover, in a case of CCD/CMOS image sensors and the like, there is a problem of dark current originating from terminals of dangling bonds, and it is therefore required to supply the escaping hydrogen and effectively utilize this hydrogen.

Meanwhile, Patent Document 2 describes a technique in which a protective insulating film for preventing the diffusion of hydrogen is formed by a plasma CVD method involving no bias application on top of an interlayer insulating film formed by an HDPCVD method involving bias application. However, both of these insulating films are SiO films, and there is no description at all regarding a film structure which uses only a SiN film to appropriately control escaping hydrogen.

The present invention has been made in view of the above problem, and an object thereof is to provide a silicon nitride film of a semiconductor element and a method and an apparatus for producing a silicon nitride film which allow appropriate control on hydrogen escaping from a silicon nitride film formed by applying bias power.

### MEANS FOR SOLVING THE PROBLEM

A silicon nitride film of a semiconductor element according to a first aspect of the invention for solving the above problem is a silicon nitride film formed on a substrate by plasma processing and to be used in a semiconductor element, wherein
in a case where the silicon nitride film is in contact with a film desired to be blocked from being supplied with hydrogen,
the silicon nitride film comprises a first silicon nitride film formed by applying bias to the substrate, and a second silicon nitride film formed without applying any bias to the substrate, and
the second silicon nitride film is disposed on a side which is in contact with the film.

A silicon nitride film of a semiconductor element according to a second aspect of the invention for solving the above problem is a silicon nitride film formed on a substrate by plasma processing and to be used in a semiconductor element, wherein
in a case where the silicon nitride film is in contact with a film desired to be supplied with hydrogen,
the silicon nitride film comprises a first silicon nitride film formed by applying bias to the substrate, and a second silicon nitride film formed without applying any bias to the substrate, and
the first silicon nitride film is disposed on a side which is in contact with the film.

A method for producing a silicon nitride film according to a third aspect of the invention for solving the above problem is a method for producing a silicon nitride film to be used in a semiconductor element by performing plasma processing to form the silicon nitride film on a substrate, wherein
in a case where the silicon nitride film is to be in contact with a film desired to be blocked from being supplied with hydrogen,
the method comprises the steps of forming a first silicon nitride film by applying bias to the substrate and forming a second silicon nitride film without applying any bias to the substrate as the silicon nitride film, and
the second silicon nitride film is formed on a side which is in contact with the film.

A method for producing a silicon nitride film according to a fourth aspect of the invention for solving the above problem is a method for producing a silicon nitride film to be used in a semiconductor element by performing plasma processing to form the silicon nitride film on a substrate, wherein
in a case where the silicon nitride film is to be in contact with a film desired to be supplied with hydrogen,
the method comprises the steps of forming a first silicon nitride film by applying bias to the substrate and forming a second silicon nitride film without applying any bias to the substrate as the silicon nitride film, and
the first silicon nitride film is formed on a side which is in contact with the film.

An apparatus for producing a silicon nitride film according to a fifth aspect of the invention for solving the above problem is an apparatus for producing a silicon nitride film to be used in a semiconductor element by performing plasma processing to form the silicon nitride film on a substrate, comprising bias supplying means for applying bias to the substrate, wherein
in a case where the silicon nitride film is to be in contact with a film desired to be blocked from being supplied with hydrogen, a first silicon nitride film and a second silicon nitride film are formed as the silicon nitride film and the second silicon nitride film is formed on a side which is in contact with the film,
when the first silicon nitride film and the second silicon nitride film are formed, the bias supplying means applies the bias to the substrate in the formation of the first silicon nitride film and applies no bias to the substrate in the formation of the second silicon nitride film.

An apparatus for producing a silicon nitride film according to a sixth aspect of the invention for solving the above problem is an apparatus for producing a silicon nitride film to be used in a semiconductor element by performing plasma processing to form the silicon nitride film on a substrate, comprising bias supplying means for applying bias to the substrate, wherein
in a case where the silicon nitride film is to be in contact with a film desired to be supplied with hydrogen, a first silicon nitride film and a second silicon nitride film are formed as the silicon nitride film and the first silicon nitride film is formed on a side which is in contact with the film,
when the first silicon nitride film and the second silicon nitride film are formed, the bias supplying means applies the bias to the substrate in the formation of the first silicon nitride film and applies no bias to the substrate in the formation of the second silicon nitride film.

### EFFECTS OF THE INVENTION

According to the first, third, and fifth aspects of the invention, the second silicon nitride film formed without applying any bias is disposed on the side which is in contact with the film desired to be blocked from being supplied with hydrogen. Accordingly, the supply of the hydrogen inside the first silicon nitride film to the film can be blocked by the second silicon nitride film.

According to the second, fourth, and sixth aspects of the invention, the first silicon nitride film formed by applying bias is disposed on the side which is in contact with the film desired to be supplied with hydrogen, and the second silicon nitride film formed without applying any bias is disposed on the opposite side. Accordingly, the hydrogen inside the first silicon nitride film can be efficiently supplied to the film.

### BRIEF DESCRIPTION OF THE DRAWINGS

[Fig. 1] Fig. 1 is a configuration diagram showing an illustrative embodiment of an apparatus for manufacturing a silicon nitride film according to the present invention.
[Fig. 2] Part (a) of Fig. 2 is a cross-sectional view showing the film structure of a silicon nitride film formed by applying bias power, and Part (b) of Fig. 2 is a graph of a measurement on stress changes in the silicon nitride film.
[Fig. 3] Part (a) of Fig. 3 is a cross-sectional view showing the film structure of a silicon nitride film formed without applying any bias power, and Part (b) of Fig. 3 is a graph of a measurement on stress changes in the silicon nitride film.
[Fig. 4] Part (a) of Fig. 4 is a cross-sectional view showing a film structure in which the silicon nitride film formed without applying any bias power and the silicon nitride film formed by applying bias power are stacked on one another, and Part (b) of Fig. 4 is a graph of a measurement on stress changes in the silicon nitride film.
[Fig. 5] Part (a) of Fig. 5 is a cross-sectional view showing a film structure in which the silicon nitride film formed by applying bias power is stacked, or sandwiched, between silicon nitride films formed without applying any bias power, and Part (b) of Fig. 5 is a graph of a measurement on stress changes in the silicon nitride film.
[Fig. 6] Parts (a) and (b) of Fig. 6 are cross-sectional views showing some illustrative embodiments of the silicon nitride film of a semiconductor element according to the present invention.
[Fig. 7] Parts (a) and (b) of Fig. 7 are cross-sectional views showing some other illustrative embodiments of the silicon nitride film of a semiconductor element according to the present invention.

### MODES FOR CARRYING OUT THE INVENTION

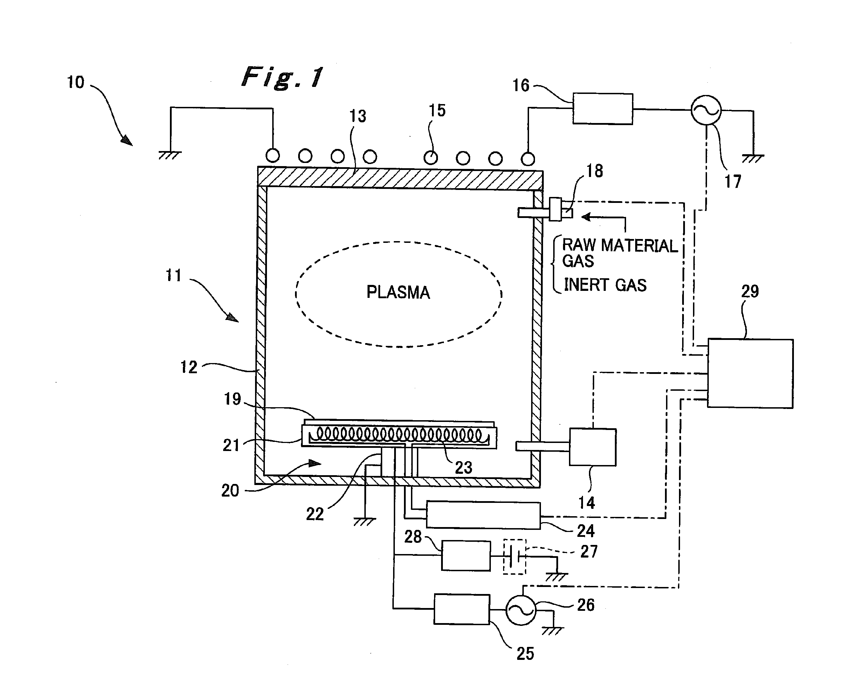

Hereinbelow, a silicon nitride film of a semiconductor element and a method and an apparatus for manufacturing a silicon nitride film according to the present invention will be described through embodiments with reference to Figs. 1 to 7.

### (Example 1)

First, the configuration of an apparatus used in this example to manufacture a silicon nitride film (SiN film) will be described with reference to Fig. 1. Note that the present invention is applicable to any apparatuses as long as they are plasma processing apparatuses which form a SiN film by applying bias power. However, plasma CVD apparatuses using high-density plasma are preferable in particular, and Fig. 1 illustrates such a plasma CVD apparatus.

As shown in Fig. 1, a plasma CVD apparatus 10 includes a vacuum chamber 11 configured to maintain a high vacuum therein. This vacuum chamber 11 is formed of a tubular container 12 and a top panel 13, and a space tightly sealed from outside air is created by attaching the top panel 13 to an upper portion of the tubular container 12. On the vacuum chamber 11, a vacuum device 14 configured to vacuum the inside of the vacuum chamber 11 is placed.

An RF antenna 15 configured to generate plasma is placed on top of the top panel 13. An RF power source 17 being a high-frequency power source is connected to the RF antenna 15 through a matching box 16. Specifically, the RF power supplied from the RF power source 17 is supplied to plasma through the RF antenna 15.

In an upper portion of a sidewall of the tubular container 12, there is placed a gas supply pipe 18 through which raw material gases serving as raw materials for a film to be formed and an inert gas are supplied into the vacuum chamber 11. A gas supply amount controller configured to control the amounts of the raw material gases and the inert gas to be supplied is placed on the gas supply pipe 18. In this example, SiH₄ and N₂, or the like are supplied as the raw material gases, while Ar which is a noble gas or the like is supplied as the inert gas. By supplying these gases, plasma of SiH₄, N₂ and Ar, or the like is generated in an upper portion of the inside of the vacuum chamber 11.

A substrate support table 20 configured to hold a substrate 19, or the film formation target, is placed in a lower portion of the inside of the tubular container 12. This substrate support table 20 is formed of a substrate holding part 21 configured to hold the substrate 19, and a support shaft 22 configured to support this substrate holding part 21. A heater 23 for heating is placed inside the substrate holding part 21. The temperature of this heater 23 is adjusted by a heater control device 24. Accordingly, the temperature of the substrate 19 during plasma processing can be controlled.

A bias power source 26 (bias supplying means) is connected to the substrate holding part 21 through a matching box 25 so that bias power can be applied to the substrate 19. Accordingly, ions can be drawn from the inside of the plasma onto the surface of the substrate 19. Further, an electrostatic power source 27 is connected to the substrate holding part 21 so that the substrate 19 can be held by electrostatic force. This electrostatic power source 27 is connected to the substrate holding part 21 through a low-pass filter 28 so that the power from the RF power source 17 and the bias power source 26 does not flow into the electrostatic power source 27.

In addition, in the plasma CVD apparatus 10 described above, there is placed a master control device 29 capable of controlling each of the bias power, the RF power, the pressure, the substrate temperature, and the gas supply amounts respectively through the bias power source 26, the RF power source 17, the vacuum device 14, the heater control device 24, and the gas supply amount controller. Here, the dashed lines in Fig. 1 mean signal lines to transmit control signals from the master control device 29 to the bias power source 26, the RF power source 17, the vacuum device 14, the heater control device 24, and the gas supply amount controller, respectively.

A SiN film can be formed on the substrate 19 through plasma processing in the plasma CVD apparatus 10 described above by controlling the bias power, the RF power, the pressure, the film formation temperature, and the gas supply amounts through the master control device 29. Not only is the plasma CVD apparatus 10 capable of forming a SIN film by applying bias power, but it is also capable of forming a SIN film without applying any bias power as a matter of course.

Here, hydrogen escape due to annealing performed in a semiconductor manufacturing process was checked for a SiN film formed by applying bias power (hereinafter, referred to as the biased SiN film) and for a SiN film formed without applying any bias power (hereinafter, referred to as the unbiased SiN film) by measuring stress changes in the SiN films.

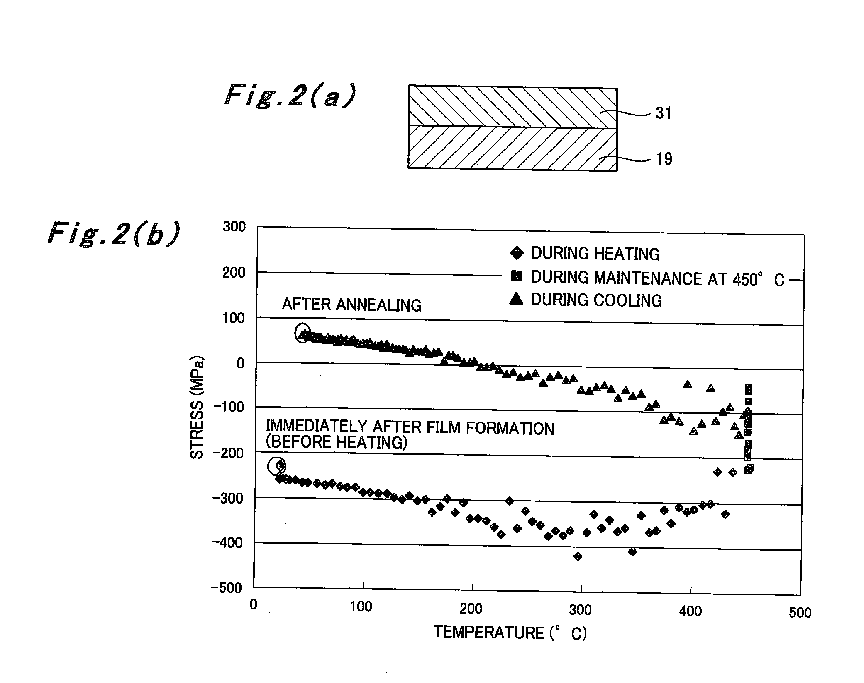

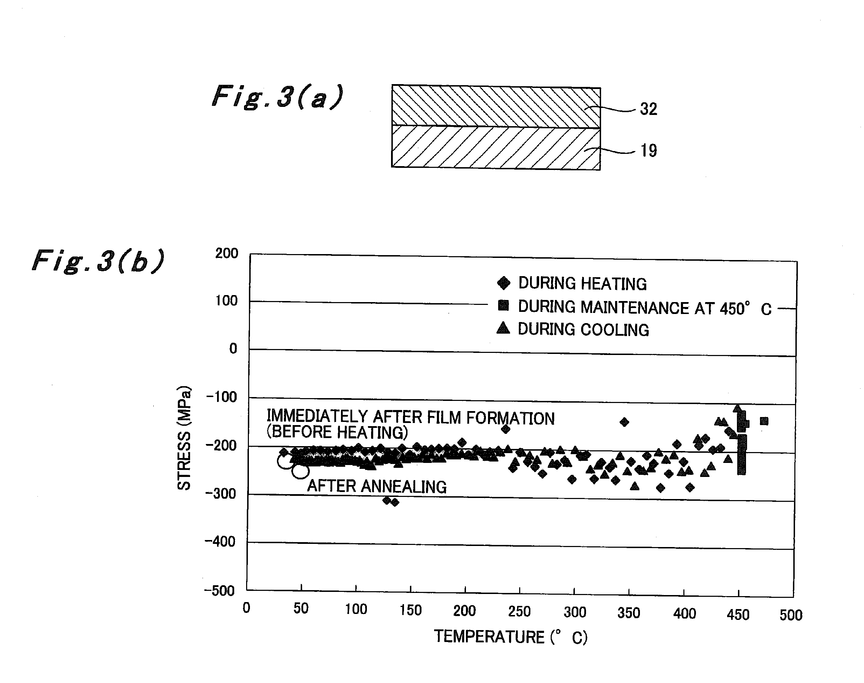

Figs. 2 and 3 describe the stress measurements on the SiN films, respectively. Specifically, Fig. 2 corresponds to the biased SiN film, and Part (a) of Fig. 2 is a cross-sectional view showing the film structure thereof while Part (b) of Fig. 2 is a graph of the measurement on stress changes therein. Moreover, Fig. 3 corresponds to the unbiased SiN film, and Part (a) of Fig. 3 is a cross-sectional view showing the film structure thereof while Part (b) of Fig. 3 is a graph of the measurement on stress changes therein.

In the stress measurement on each SiN film, as for the stress measurement device, FLX-2320 manufactured by KLA-Tencor was used. Moreover, as for the stress measurement method, in a heater inside the stress measurement device, a substrate with the SiN film formed thereon was heated from normal temperature to 450°C by spending 1 hour, maintained at 450°C for 30 minutes, and then cooled down, and the stress changes during these periods were measured. This stress measurement method used 450°C which produced a larger temperature load than with 400°C being the temperature of the annealing performed in the semiconductor manufacturing process.

Meanwhile, the film formation condition for each SiN film was as follows.

### [Biased SiN Film]

RF power: 2.0 kW, Bias power: 2.4 kW, SiH₄: 40 sccm, N₂: 80 sccm, Ar: 20 sccm, Pressure 25 mTorr, Film thickness 4513 Å

### [Unbiased SiN Film]

RF power: 3.0 kW, Bias power: 0 kW, SiH₄: 30 sccm, N₂: 800 sccm, Ar: 0 sccm, Pressure 25 mTorr, Film thickness 4226 Å]
Note that this film formation condition is only an example. In the case of the unbiased SiN film, falling within the following film formation condition can offer later-described properties:
Film formation temperature: 50°C to 400°C
RF power with respect to the total flow rate of SiH₄ and N₂: 7 W/sccm or lower
Gas flow ratio: SiH₄/(SiH₄+N₂) = 0.036 to 0.33

As shown in Part (a) of Fig. 2, a biased SiN film 31 was formed on a Si substrate 19 under the film formation condition described above. As a result of measuring the formed biased SiN film 31 together with the Si substrate 19 by the stress measurement method described above, the stress immediately after the film formation was found to be a compressive stress of -254 MPa. Moreover, as shown in Part (b) of Fig. 2, the stress changed from a compressive stress to a tensile stress over the process from heating to cooling, and ended up as a tensile stress of 65 MPa after the annealing. This was because the biased SiN film 31 contained a large amount of hydrogen (particularly, hydrogen in Si-H bonds), so that a larger amount of hydrogen than otherwise escaped by the annealing and that hydrogen escape caused the changes in film stress. Accordingly, it is possible to supply hydrogen by annealing the biased SiN film 31.

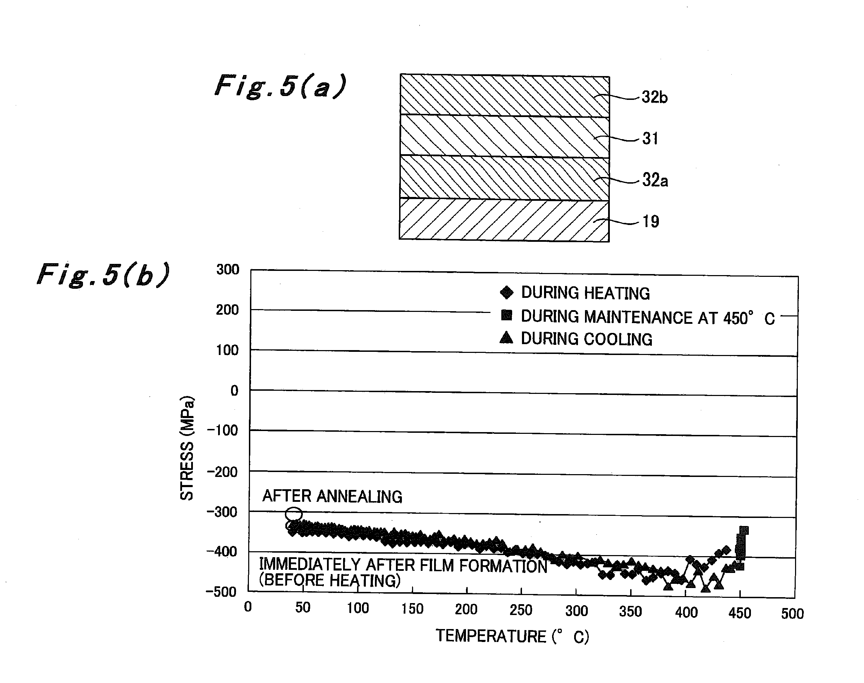

Moreover, as shown in Part (a) of Fig. 3, an unbiased SiN film 32 was also formed on the Si substrate 19 under the film formation condition described above. As a result of measuring the formed unbiased SiN film 32 together with the Si substrate 19 by the stress measurement method described above, the stress immediately after the film formation was found to be a compressive stress of -230 MPa. Moreover, as shown in Part (b) of Fig. 3, the compressive stress decreased while the temperature was maintained at 450°C, but the stress changed in substantially the same manner during the heating and during the cooling and ended up as a compressive stress of -225 MPa after the annealing. Thus, substantially the same compressive stress was found before and after the annealing. This was because the unbiased SiN film 32 contained a small amount of hydrogen (particularly, hydrogen in Si-H bonds) and also had a dense film quality suppressing the transfer (permeation) of hydrogen, so that the amount of hydrogen escaping due to the annealing was small, which in turn held the film stress changes to a small level. Accordingly, annealing the unbiased SiN film 32 does not result in the supply of hydrogen from the unbiased SiN film 32 or the permeation of hydrogen therethrough not only from within itself but also from within some other film. Thereby, it is possible to block the diffusion of hydrogen. The blocking of the diffusion of hydrogen will be described further in detail in later-described Fig. 5.

Meanwhile, the hydrogen content of each SiN film was checked through an IR analysis (infrared analysis, e.g. FTIR or the like). As shown in Table 1, the hydrogen content of the biased SiN film is 5.1×10²¹ [atoms/cm³] while the hydrogen content of the unbiased SiN film is 0.1×10²¹ [atoms/cm³] . Thus, the hydrogen content of the unbiased SiN film is 2% or below of the hydrogen content of the biased SiN film, showing that the unbiased SiN film is a dense film with a small hydrogen content. Note that in this instance, as the hydrogen content of each SiN film, the number of Si-H bonds found based on the peak area of Si-H bonds present around 2140 cm⁻¹ was measured.

**[Table 1]**

| | Si-H Bonds [bonds/cm³] |
|---|---|
| Biased SiN Film | 5.1×10²¹ |
| Unbiased SiN Film | 0.1×10²¹ |

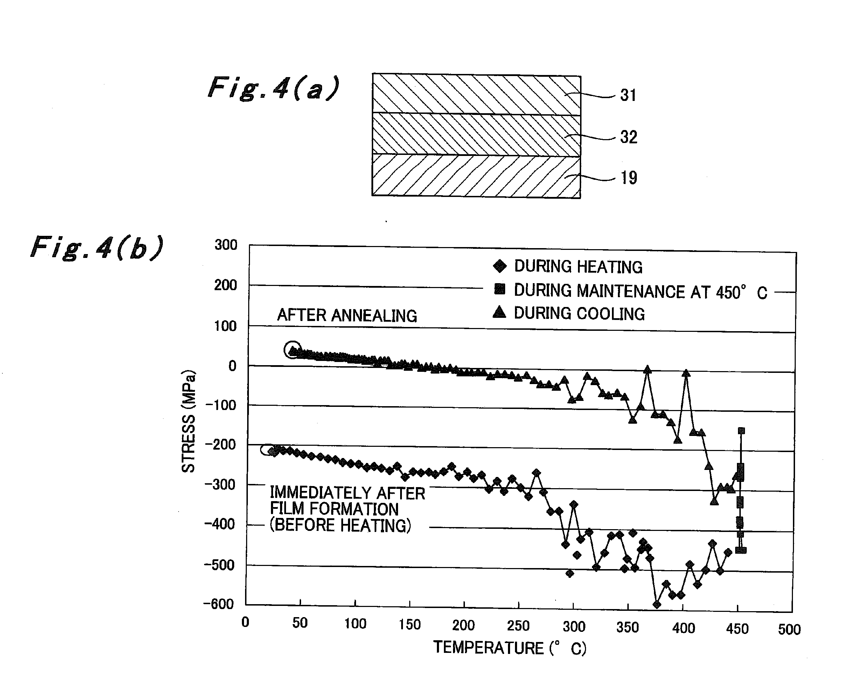

Next, the unbiased SiN film 32 was formed on the Si substrate 19 and the biased SiN film 31 was stacked thereon as shown in Part (a) of Fig. 4, and stress changes therein were measured. As the film formation condition for each SiN film in this instance, the above-described film formation condition was used, except that the film thickness of each SiN film was changed. The film thickness of the unbiased SiN film 32 was set to 1000 Å, and the film thickness of the biased SiN film 31 was set to 3000 Å.

As a result of measuring the stacked unbiased SiN film 32 and biased SiN film 31 together with the Si substrate 19 by the stress measurement method described above, the stress immediately after the film formation was found to be a compressive stress of -218 MPa. Moreover, as shown in Part (b) of Fig. 4, the stress changed from a compressive stress to a tensile stress over the process from heating to cooling, and ended up as a tensile stress of 29 MPa after the annealing. Similar to what was shown in Fig. 2, this was because the biased SiN film 31 contained a large amount of hydrogen (particularly, hydrogen in Si-H bonds), so that a larger amount of hydrogen than otherwise escaped by the annealing and that hydrogen escape caused the changes in film stress. Thus, in the film structure shown in Part (a) of Fig. 4, the hydrogen escape from the biased SiN film 31 is not suppressed due to the presence of the unbiased SiN film 32 on the lower side of the biased SiN film 31. Accordingly, it is possible to supply hydrogen by annealing the biased SiN film 31.

Next, an unbiased SiN film 32a was formed on the Si substrate 19, the biased SiN film 31 was stacked thereon, and an unbiased SiN film 32b was stacked thereon as shown in Part (a) of Fig. 5, and stress changes therein were measured. In other words, provided was a structure sandwiching the biased SiN film 31 between the unbiased SiN film 32a and the unbiased SiN film 32b. As the film formation condition for each SiN film in this instance, the above-described film formation condition was used as well, except that the film thickness of each SiN film was changed. The film thickness of each of the unbiased SiN films 32a and 32b was set to 1000 Å, and the film thickness of the biased SiN film 31 was set to 3000 Å.

As a result of measuring the stacked unbiased SiN film 32a, biased SiN film 31, and unbiased SiN film 32b together with the Si substrate 19 by the stress measurement method described above, the stress immediately after the film formation was found to be a compressive stress of -354 MPa. Moreover, as shown in Part (b) of Fig. 5, the stress changed in substantially the same manner during the heating and during the cooling and ended up as a compressive stress of -328 MPa after the annealing. Thus, substantially the same compressive stress was found before and after the annealing. This was because the unbiased SiN films 32a and 32b contained a small amount of hydrogen (particularly, hydrogen in Si-H bonds) and further the biased SiN film 31 was sandwiched between the unbiased SiN films 32a and 32b, so that the escape of the hydrogen inside the biased SiN film 31 was suppressed even when annealing was performed, which in turn held the film stress changes to a small level. Accordingly, annealing the biased SiN film 31 does not result in the supply of hydrogen from the biased SiN film 31 due to the presence of the unbiased SiN films 32a and 32b. In other words, the unbiased SiN films 32a and 32b do not let the hydrogen inside the biased SiN film 31 permeate therethrough and are therefore capable of blocking the diffusion of the hydrogen.

As can be appreciated from the graphs shown in Part (b) of Fig. 4 and Part (b) of Fig. 5, while it is possible to supply hydrogen by annealing the biased SiN film 31, whether to supply or to block it can be controlled by the arrangement of the unbiased SiN film 32 (or the unbiased SiN films 32a and 32b).

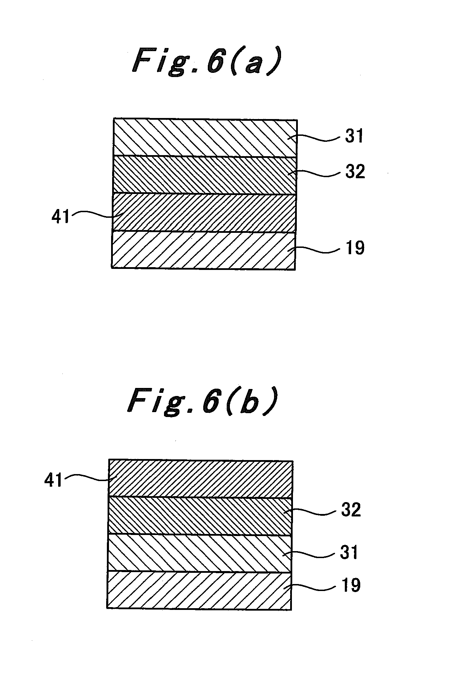

Thus, in this example, in order to block the diffusion (supply) of the hydrogen inside the biased SiN film 31 (first silicon nitride film), the unbiased SiN film 32 (second silicon nitride film) is disposed on the side (s) where the diffusion is desired to be blocked. Specifically, as shown in Part (a) of Fig. 6, in a case where a film 41 desired to avoid the diffusion of hydrogen thereto is present below the biased SiN film 31, the unbiased SiN film 32 is disposed on the lower side of the biased SiN film 31, that is, between the biased SiN film 31 and the film 41. Moreover, as shown in Part (b) of Fig. 6, in a case where the film 41 desired to avoid the diffusion of hydrogen thereto is present above the biased SiN film 31, the unbiased SiN film 32 is disposed on the upper side of the biased SiN film 31, that is, between the biased SiN film 31 and the film 41. Thus, in a case where the SiN film (the biased SiN film 31 and the unbiased SiN film 32) is in contact with the film 41, the unbiased SiN film 32 is disposed on the side which is in contact with the film 41.

As mentioned above, since the unbiased SiN film 32 has a small hydrogen content and is dense, inserting it between the biased SiN film 31 and the film 41 allows the blocking of the diffusion of the hydrogen inside the biased SiN film 31 even when annealing is performed. Accordingly, it is possible to perform annealing in a semiconductor manufacturing process while maintaining the embedding performance offered by the biased SiN film 31. Note that the film 41 desired to avoid the diffusion of hydrogen thereto include a ferroelectric film of a ferroelectric memory, for example, and using the above configuration can prevent deterioration of the ferroelectric film due to hydrogen reduction.

### (Example 2)

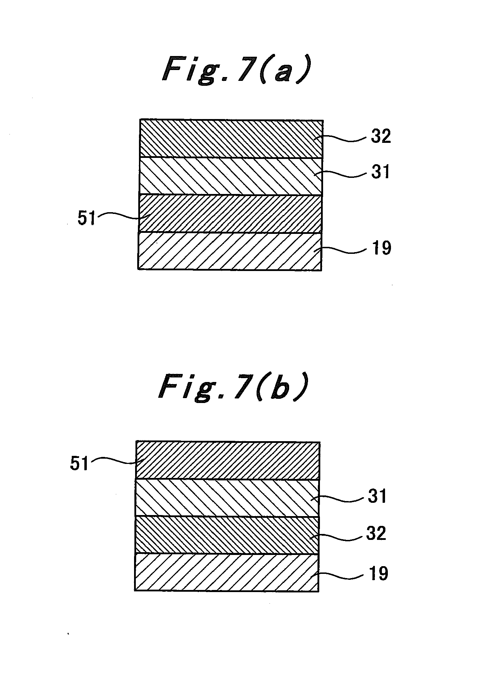

Parts (a) and (b) of Fig. 7 are cross-sectional views describing a SiN film of this example. Note that since this example can be manufactured by use of the plasma CVD apparatus shown in Fig. 1 or the like, description of the plasma CVD apparatus itself is omitted in this section.

In this example, in order to supply the hydrogen inside a biased SiN film 31 to an upper or lower side thereof, an unbiased SiN film 32 is disposed on the opposite side to the side where the hydrogen is desired to be supplied. Specifically, as shown in Part (a) of Fig. 7, in a case where a film 51 desired to be supplied with hydrogen is present below the biased SiN film 31, the unbiased SiN film 32 is disposed on the upper side of the biased SiN film 31. Moreover, as shown in Part (b) of Fig. 7, in a case where the film 51 desired to be supplied with hydrogen is present above the biased SiN film 31, the unbiased SiN film 32 is disposed on the lower side of the biased SiN film 31. Thus, in a case where the SiN film (the biased SiN film 31 and the unbiased SiN film 32) is in contact with the film 51, the biased SiN film 31 is disposed on the side which is in contact with the film 51, and the unbiased SiN film 32 is disposed on the opposite side.

As mentioned above, since the unbiased SiN film 32 has a small hydrogen content and is dense, disposing it on the opposite side of the biased SiN film 31 from the film 51 (the upper side in Part (a) of Fig. 7 and the lower side in Part (b) of Fig. 7) allows the hydrogen inside the film to be diffused only to the film 51 side of the biased SiN film 31 (the lower side in Part (a) of Fig. 7 and the upper side in Part (b) of Fig. 7) when annealing is performed. Thus, the hydrogen inside the film can be supplied efficiently. Accordingly, it is possible to perform annealing in a semiconductor manufacturing process while maintaining the embedding performance offered by the biased SiN film 31. Note that the film 51 desired to be supplied with hydrogen includes a semiconductor film of a CCD/CMOS image sensor, for example, and using the above configuration can supply hydrogen to terminals of dangling bonds in the semiconductor film and thereby reduce the dark current of the CCD/CMOS image sensor.

### INDUSTRIAL APPLICABILITY

The present invention is applicable to silicon nitride films used in semiconductor elements, and is preferable particularly for the lenses of CCD/CMOS image sensors and the final protection films (passivation) of wirings.

### EXPLANATION OF THE REFERENCE NUMERALS

| | |
|---|---|
| 10 | plasma CVD apparatus |
| 18 | gas supply pipe |
| 19 | substrate |
| 26 | bias power source |
| 29 | master control device |
| 31 | biased SiN film |
| 32, 32a, 32b | unbiased SiN film |

## Claims

1. A silicon nitride film of a semiconductor element formed on a substrate by plasma processing and to be used in the semiconductor element, wherein
in a case where the silicon nitride film is in contact with a film desired to be blocked from being supplied with hydrogen,
the silicon nitride film comprises a first silicon nitride film formed by applying bias to the substrate, and a second silicon nitride film formed without applying any bias to the substrate, and
the second silicon nitride film is disposed on a side which is in contact with the film.

2. A silicon nitride film of a semiconductor element formed on a substrate by plasma processing and to be used in the semiconductor element, wherein
in a case where the silicon nitride film is in contact with a film desired to be supplied with hydrogen,
the silicon nitride film comprises a first silicon nitride film formed by applying bias to the substrate, and a second silicon nitride film formed without applying any bias to the substrate, and
the first silicon nitride film is disposed on a side which is in contact with the film.

3. A method for producing a silicon nitride film to be used in a semiconductor element by performing plasma processing to form the silicon nitride film on a substrate, wherein
in a case where the silicon nitride film is to be in contact with a film desired to be blocked from being supplied with hydrogen,
the method comprises the steps of forming a first silicon nitride film by applying bias to the substrate and forming a second silicon nitride film without applying any bias to the substrate as the silicon nitride film, and
the second silicon nitride film is formed on a side which is in contact with the film.

4. A method for producing a silicon nitride film to be used in a semiconductor element by performing plasma processing to form the silicon nitride film on a substrate, wherein
in a case where the silicon nitride film is to be in contact with a film desired to be supplied with hydrogen,
the method comprises the steps of forming a first silicon nitride film by applying bias to the substrate and forming a second silicon nitride film without applying any bias to the substrate as the silicon nitride film, and
the first silicon nitride film is formed on a side which is in contact with the film.

5. An apparatus for producing a silicon nitride film to be used in a semiconductor element by performing plasma processing to form the silicon nitride film on a substrate, comprising bias supplying means for applying bias to the substrate, wherein
in a case where the silicon nitride film is to be in contact with a film desired to be blocked from being supplied with hydrogen, a first silicon nitride film and a second silicon nitride film are formed as the silicon nitride film and the second silicon nitride film is formed on a side which is in contact with the film,
when the first silicon nitride film and the second silicon nitride film are formed, the bias supplying means applies the bias to the substrate in the formation of the first silicon nitride film and applies no bias to the substrate in the formation of the second silicon nitride film.

6. An apparatus for producing a silicon nitride film to be used in a semiconductor element by performing plasma processing to form the silicon nitride film on a substrate, comprising bias supplying means for applying bias to the substrate, wherein
in a case where the silicon nitride film is to be in contact with a film desired to be supplied with hydrogen, a first silicon nitride film and a second silicon nitride film are formed as the silicon nitride film and the first silicon nitride film is formed on a side which is in contact with the film,
when the first silicon nitride film and the second silicon nitride film are formed, the bias supplying means applies the bias to the substrate in the formation of the first silicon nitride film and applies no bias to the substrate in the formation of the second silicon nitride film.
